# EUROPEAN PATENT APPLICATION

(11) **EP 4 704 141 A1**
(43) Date of publication of application: **04.03.2026**
(21) Application number: 25182823.2
(22) Date of filing: 13.06.2025
(51) Int. Cl.: H01L 21/311, H10N 30/082

(54) **METHOD OF PLASMA ETCHING**

(30) Priority: 03.09.2024 GB 202412922
(71) Applicant: SPTS Technologies Limited, NP18 2TA (GB)
(72) Inventor: KAZEMI, Samira Binte, Newport (GB)
(74) Representative: Wynne-Jones IP Limited

(57) **Abstract**

An apparatus and method are disclosed for plasma etching an additive-containing aluminium nitride film containing an additive element selected from scandium (Sc), yttrium (Y) or erbium (Er). The method comprises the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
introducing BCl₃ gas into the chamber with a BCl₃ flow rate in sccm;
introducing H₂ gas into the chamber with a H₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the BCl₃ flow rate is in the range 1:3 to 1:11 and a ratio of the BCl₃ flow rate to the H₂ flow rate is in the range 11:1 to 2:1.

## Description

This invention relates to a method of plasma etching, with particular reference to a method of plasma etching an additive-containing aluminium nitride film, the additive-containing aluminium nitride film containing an additive element selected from scandium (Sc), yttrium (Y) or erbium (Er). The invention relates also to an associated apparatus for plasma etching an additive-containing aluminium nitride film of this kind.

Aluminium nitride (AIN) and aluminium scandium nitride (AlScN) piezoelectric devices are widely used in a range of RF technologies such as bulk acoustic wave (BAW) devices, piezoelectric micromachined ultrasonic transducers (PMUTs), lamb wave contour mode resonators (CMR), microphones and sensors. Mobile phones typically incorporate a number of AIN and AlScN BAW devices and the generation of higher operating frequencies require the use of thinner BAW devices. Improving the piezoelectric performance for thinner devices is a major challenge as tolerances become tighter and the integration of these devices on circuit boards becomes more complicated. The addition of Sc is known to improve the piezoelectric properties of BAW devices. However, there are a number of problems associated with the etching of AlScN which are particularly troublesome with high scandium contents.

As the percentage of Sc in doped AIN increases, the etch rate typically decreases when using standard chlorine (Cl₂)/argon (Ar) based chemistries. This decrease results in a lower AlScN selectivity to masks (such as photoresist or SiO₂ masks), which increases the critical dimension (CD) and consequently results in a shallower sidewall angle within the AlScN trenches. Common methods of controlling the sidewall profile include adjusting the slope of the pre-etch mask, changing the platen bias, etchant gas flow or process pressure. These methods are commonly effective for lower Sc content AlScN, but at higher Sc percentages the etch becomes increasingly physical, decreasing the overall effectiveness of these methods. Similar effects are observed with AlYN and AlErN films.

The decrease in AlScN etch rate also reduces the selectivity to metal underlayers, leading to increased underlayer loss which can impair the performance of some devices, such as BAW filters. The lower electrical contact to BAW devices is typically molybdenum (Mo), tungsten (W) or platinum (Pt) and if excessive amounts of metal are removed, owing to the reduced etch rate of AlScN, the electrical resistance of the contact will increase, resulting in a degradation of device performance. Typical changes to increase the AlScN etch rate, such as increased platen bias or increased Cl₂ flow may ultimately have little-to-no impact on the sidewall angle or underlayer selectivity, or in some cases may even exacerbate the issue.

AlScN etch processes typically comprise two etch steps. The first step is a main, bulk etch process with a high etch rate, good selectivity to the mask material, a steep sidewall profile, and minimum footing (for the avoidance of doubt, footing refers to an undesirable deviation away from an ideal flat bottom surface at the base of an etched feature). Normally 80-85% of the material is etched by the main etch. The second step is a soft-landing etch step which should have good selectivity to the underlying electrode. This is generally a low etch rate process. As this process typically etches only 15-20% of the material, the etch rate and the etch profile can be sacrificed for good selectivity.

The present invention, in at least some of its embodiments, seeks to improve AlScN:Mo selectivity to minimize electrode loss.

According to a first aspect of the invention, there is provided a method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
introducing BCl₃ gas into the chamber with a BCl₃ flow rate in sccm;
introducing H₂ gas into the chamber with a H₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the BCl₃ flow rate is in the range 1:3 to 1:11 and a ratio of the BCl₃ flow rate to the H₂ flow rate is in the range 11:1 to 2.25:1.

In this way, improved selectivity to metal underlayers can be achieved. Selectivity can be defined as the etch rate of the additive-containing aluminium nitride film / the etch rate of the metal film.

The ratio of the inert diluent gas flow rate to the BCl₃ flow rate can be in the range 1:5 to 1:6.

The ratio of the BCl₃ flow rate to the H₂ flow rate can be in the range 5.7:1 to 3.8:1.

The BCl₃ flow rate can be in the range 90 to 110 sccm, the inert diluent gas flow rate can be in the range 10 to 30 sccm and the H₂ gas flow rate can be in the range 10 to 40 sccm.

An RF bias signal having a power in the range 500-700W can be applied to the substrate support during the plasma etch step.

According to a second aspect of the invention, there is provided a method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
performing a first plasma etching step in which BCl₃ gas, Cl₂ gas and an inert diluent gas are introduced into the chamber and a plasma is established within the chamber to plasma etch a majority of the additive-containing aluminium nitride film exposed within the trench; and
performing a second plasma etching step to plasma etch the remaining additive-containing aluminium nitride film exposed within the trench to reveal the metal film, the second plasma etching step comprising:
   introducing BCl₃ gas into the chamber with a BCl₃ flow rate in sccm;
   introducing H₂ gas into the chamber with a H₂ flow rate in sccm;
   introducing an inert diluent gas into the chamber with an inert diluent gas flow rate in sccm; and
   establishing a plasma within the chamber to plasma etch the additive-containing aluminium nitride film exposed within the trench;
   wherein during the second plasma etching step, a ratio of the inert diluent gas flow rate to the BCl₃ flow rate is in the range 1:3 to 1:11 and a ratio of the BCl₃ flow rate to the H₂ flow rate is in the range 11:1 to 2.25:1.

The second plasma etching step takes place separately to the first plasma etching step. In an embodiment, the second plasma etching step takes place immediately after the first plasma etching step. The second plasma etching step can comprise any of the features of the method of the first aspect of the invention.

In an embodiment, the Cl₂ gas is not introduced into the chamber during the second plasma etching step.

The inert diluent gas can be Argon and the metal film can be a molybdenum film.

The mask can be a photoresist mask.

The plasma can be an inductively coupled plasma (ICP).

The substrate can be a semiconductor substrate, such as a silicon substrate.

The additive-containing aluminium nitride film can be an aluminium scandium nitride film defined by the formula AlₓSc_{y}N, where x + y = 1; and wherein the scandium content y is at least 0.35.

According to a third aspect of the invention, there is provided an apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas with a BCl₃ flow rate in sccm, H₂ gas with a H₂ flow rate in sccm and an inert diluent gas with an inert diluent flow rate in sccm;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform plasma etching to etch the additive-containing aluminium nitride film exposed within the trench, wherein the controller controls the gas delivery system to maintain a ratio of the inert diluent gas flow rate to the BCl₃ flow rate in the range 1:3 to 1:11 and a ratio of the BCl₃ flow rate to the H₂ flow rate is in the range 11:1 to 2:1.

According to a fourth aspect of the invention, there is provided an apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas, Cl₂ gas, H₂ gas and an inert diluent gas;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform:
   a first plasma etching step in which BCl₃ gas, Cl₂ gas and an inert diluent gas are introduced into the chamber and a plasma is established within the chamber to etch a majority of the additive-containing aluminium nitride film exposed within the trench, and
   a second plasma etching step in which BCl₃ gas, H₂ gas and an inert diluent gas are introduced into the chamber, such that during the second plasma etching step, a ratio of the inert diluent gas flow rate to the BCl₃ flow rate in the range 1:3 to 1:11 and a ratio of the BCl₃ flow rate to the H₂ flow rate is in the range 11:1 to 2:1, and a plasma is established within the chamber to etch the remaining additive-containing aluminium nitride film exposed within the trench to reveal the metal film.

Whilst the invention has been described above, it extends to any inventive combination of the features set out above, or in the following description, drawings or claims. For example, any features disclosed in relation to one aspect of the invention can be combined with any features disclosed in relation to the any other aspect of the invention.

Embodiments of the invention will now be described by way of example only and with reference to the accompanying drawings, in which:
Figure 1 is schematic illustration of a plasma etching apparatus for etching an additive-containing aluminium nitride film;
Figure 2 is a schematic illustration of the steps associated with a method according to an embodiment of the present invention; and
Figure 3 is a cross-sectional schematic representation of a workpiece (a) prior to etching, (b) after etching.

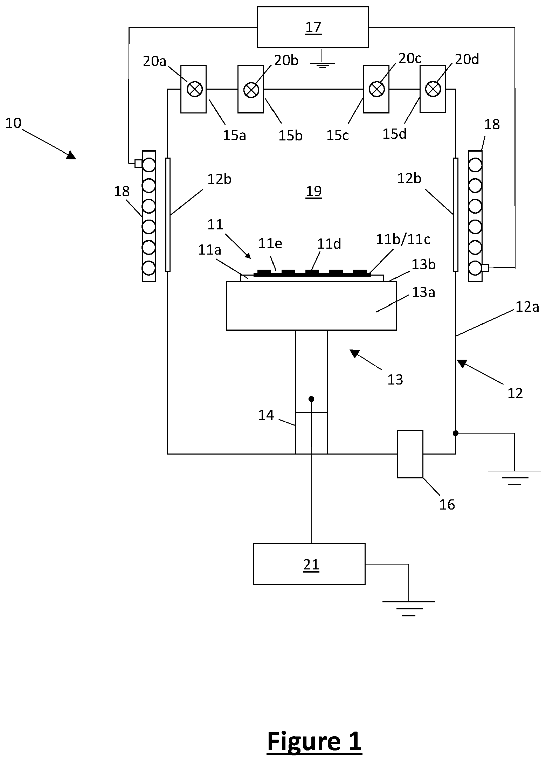

Referring to Figure 1 of the drawings, there is provided a schematic illustration of an apparatus 10 for plasma etching a workpiece 11, and comprises a process chamber 12, within which the plasma etching of the workpiece 11 is performed.

The apparatus 10 further comprises a substrate support 13. The substrate support can be a platen assembly 13, which may also be formed of a metal, such as aluminium, disposed within the chamber 12, but which is electrically isolated from the chamber walls 12a by conventional means, such as ceramic breaks 14. The substrate support can also comprise an electrostatic chuck (ESC), which can be attached to the surface of the platen assembly. The platen assembly 13 comprises a body 13a having a support surface 13b for receiving the workpiece 11 and is electrically biased using a radio frequency (RF) voltage generator 21. The provision of a negative bias voltage to the platen assembly 13 for example, can help to control positively charged ion bombardment of the surface of the workpiece 11 from the plasma.

The process chamber 12 comprises chamber walls 12a which may be formed of a metal, such as aluminium for example, and which are typically electrically grounded. The chamber 12 further comprises a first, second, third and a fourth gas inlet 15a, 15b, 15c, 15d via which a source of BCl₃ gas, Cl₂ gas, an inert diluent gas such as argon and H₂ gas (not shown) respectively, can fluidly couple for introducing the gases into the chamber 12. The chamber 12 further comprises an outlet 16, via which the gases and any by-products of the etching process can pass out from the chamber 12.

In an embodiment, the plasma is an inductively coupled plasma (ICP) generated by applying an RF voltage from an RF voltage generator 17, to one or more antenna 18, which are disposed around the chamber 12 and located adjacent a respective dielectric window section 12b formed in the chamber walls 12a. The one or more antenna 18 may comprise a substantially planar spiral configuration, a helical coil configuration or a toroidal configuration, for example, and as with standard practice, impedance matching of the RF signal from the generator 17 with the antenna 18 is carried out to minimize reflection of electrical power from the antenna 18. The antennas 18 are placed around the chamber 12 and the electrical power is inductively coupled into the chamber 12, through the dielectric window sections 12b. However, in an alternative embodiment which is not illustrated, the plasma can be generated with a so-called immersed ICP coil, which comprises an antenna formed into a helical configuration that extends within and around an annular ceramic housing which is "immersed" within the plasma chamber 12.

A plasma is generated in a region 19 of the chamber 12 which is disposed above the workpiece 11 so that the workpiece 11 becomes exposed to the plasma. The flow rate of the process gases into the chamber 12 is controlled via a respective flow regulator or mass flow controller 20a, 20b, 20c, 20d coupled with the respective inlet 15a, 15b, 15c, 15d, and the inlets 15a, 15b, 15c, 15d and outlet 16 of the chamber 12 are disposed on opposite sides of the plasma region 19 so that the etching gases are required to pass through the chamber 12, via the region 19 and over the workpiece 11, in passing to the outlet 16. An example of a suitable apparatus which can be used to perform the invention is a Synapse (RTM) module produced by the applicant, SPTS Technologies Limited.

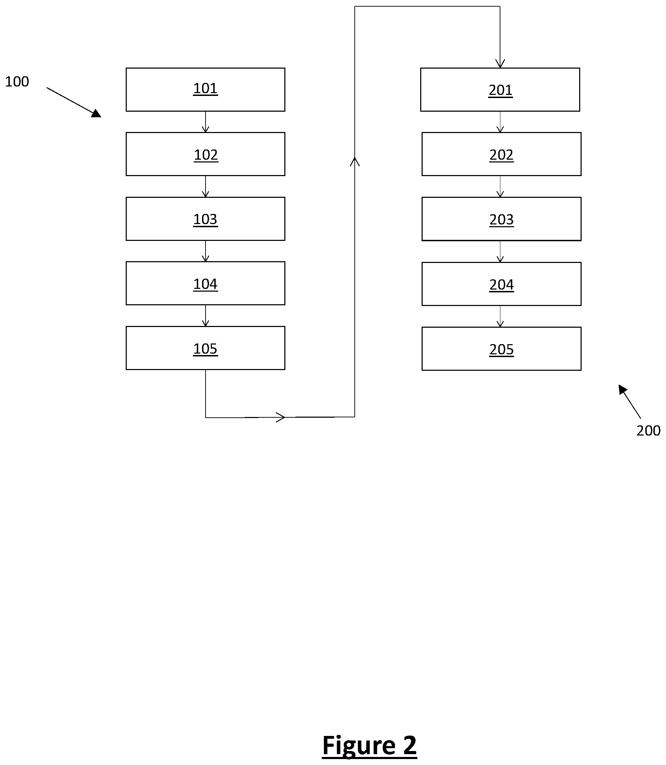

Referring to figure 2 of the drawings, there is illustrated a flow chart outlining the steps associated with a method 100 for plasma etching an additive-containing aluminium nitride film according to an embodiment of the present invention. The method will be demonstrated with reference to an AlScN film, but the skilled reader will recognize that the method is equally applicable to AlYN films and AlErN films.

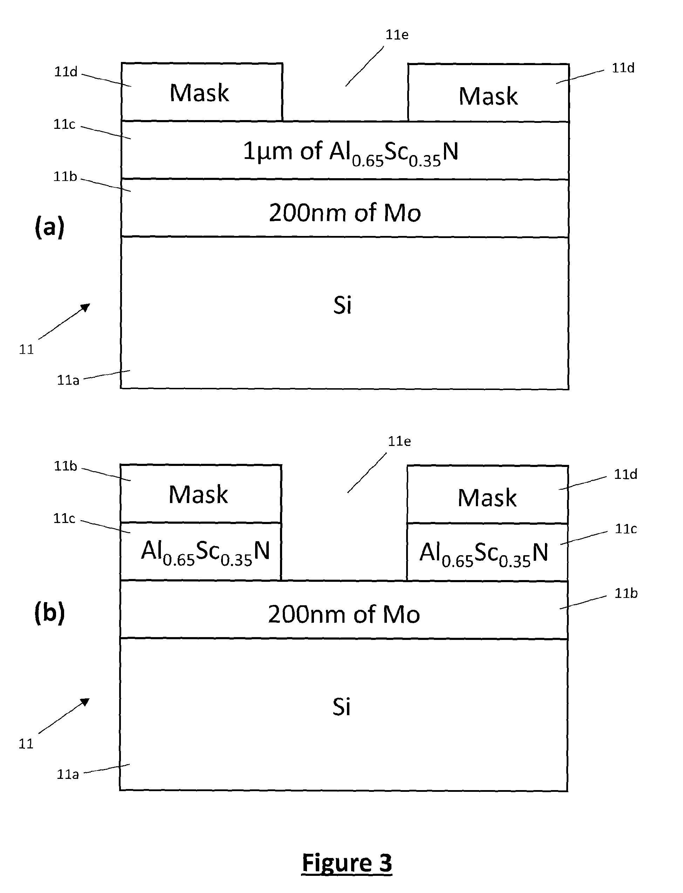

The method comprises placing a workpiece 11 upon a platen 13 within the plasma chamber 12 at step 101. Referring to figure 3 of the drawings, the workpiece 11 comprises a substrate 11a, such as a silicon wafer substrate, upon which is deposited a metal film layer 11b, such as a Molybdenum film. A piezoelectric AlScN film 11c is deposited upon the metal film layer 11b using a pulsed DC sputtering technique, for example. In an embodiment, the film comprises Al_{0.65}Sc_{0.35}N, namely a film comprising 65% component of aluminium and a 35% component for scandium. Film composition determination is typically achieved through the use of Energy Dispersive Analysis of X-rays (EDAX). The workpiece 11 further comprises a mask 11d patterned with 5µm-100µm trenches 11e formed upon the film 11c using 4-4.4mm of photoresist.

With the workpiece 11 positioned upon the platen 13 within the chamber 12, BCl₃ gas, Cl₂ gas and the inert diluent gas are introduced into the chamber 12 via the respective inlet 15a-c using the respective flow regulator 20a-c at step 102, and the pressure within the chamber 12 is maintained at approximately 2-5mTorr or substantially 2mTorr by a pressure regulator (not shown). Once the chamber 12 has been suitably conditioned with the gases, an RF potential is applied to the antenna 18 at step 103, via generator 17 to inductively couple electrical power into the gases, and thus initiate a plasma and commence the etching of the Al_{0.65}Sc_{0.35}N film. A bias voltage is also applied to the platen assembly 13 at step 104, through the use of the voltage generator 21, typically operating at 13.56MHz, to provide an etching of the Al_{0.65}Sc_{0.35}N film 11c at step 105.

In a first plasma etching step or main etching step, the antenna 18 is powered with an electrical power of approximately 1000W and the platen 13 is powered with an electrical power of approximately 1300W. The flow regulator 20a is arranged to deliver BCl₃ into the chamber 12 with a flow rate of substantially 25sccm, and the Cl₂ gas is delivered into the chamber 12 at a rate of substantially 25sccm, as determined by flow regulator 20b. Similarly, the inert diluent gas is introduced into the chamber 12 at a rate of substantially 25sccm, as determined by flow regulator 20c. In this respect, the ratio of the flow rate of the BCl₃ gas to the Cl₂ gas into the chamber 12 is approximately 1:1, and the ratio of the flow rate of the BCl₃ gas to the Ar gas into the chamber 12 is approximately 1:1. Using these process conditions, a majority of the Al_{0.65}Sc_{0.35}N film 11c can be readily etched during the main etching step 100 to provide for a suitable productivity rate. This main step provides for a good selectivity to the mask and a steep trench side-wall. However, once the majority of the Al_{0.65}Sc_{0.35}N film 11c has been etched it is beneficial to cease the main etching step 100 and commence a second etching step or so-called "soft-landing" step 200, in order to minimize any undesirable etching of the underlying metal film layer 11b. This soft-landing step is typically a low etch rate process.

The soft-landing step 200 typically utilizes a lower platen bias to decrease the underlayer etch rate and the subsequent loss of the metal film layer 11b. Upon referring to table 1 (below), it is evident that the plasma generating device 17 is powered with approximately twice the electrical power during the main etch compared with the soft-landing etch. Similarly, the platen 13 is powered with approximately 50% of the electrical power during the soft-landing etch compared with the main etch.

**Table 1**

| **Parameter** | **Main Etch** | **Soft Landing** |
|---|---|---|
| Pressure (mTorr) | 2 | 3 |
| Source power (W) | 1000 | 500 |
| Platen power (W) | 1300 | 550 |
| BCl₃ flow rate (sccm) | 25 | 102 |
| Cl₂ flow rate (sccm) | 25 | 0 |
| Ar flow rate (sccm) | 25 | 18 |
| H₂ flow rate (sccm) | 0 | See table 2 |

During the soft-landing step of the method according to an embodiment of the present invention, inlet 15b is closed at step 201 to prevent Cl₂ gas from entering the chamber and inlets 15a and 15c-d are opened to introduce BCl₃, the diluent inert gas, such as Argon, and H₂ gas respectively into the chamber 12 at step 202. The pressure within the chamber 12 is maintained at approximately 2-5mTorr or substantially 3mTorr by a pressure regulator (not shown). Once the chamber 12 has been suitably conditioned with the gases, an RF potential is applied to the antenna 18 at step 203, via generator 17 to inductively couple electrical power into the gases, and thus initiate a plasma and commence the etching of the residual Al_{0.65}Sc_{0.35}N film within the trench 11e. Similar to the main etching step, a bias voltage is also applied to the platen assembly 13 at step 204 through the use of the voltage generator 21, typically operating at 13.56MHz, to provide an etching of the residual Al_{0.65}Sc_{0.35}N film 11c at step 205.

The flow regulator 20a is arranged to deliver BCl₃ into the chamber 12 with a flow rate of substantially 102sccm and the Argon gas is delivered into the chamber 12 at a rate of substantially 18sccm, as determined by flow regulator 20c. In an endeavor to demonstrate the effect of the H₂ gas on the AlScN:Mo selectivity, the soft-landing step was performed using three separate H₂ flow rates into the chamber, using regulator 20d, as set out in Table 2 below.

**Table 2**

| | Ar flow (sccm) | BCl₃ flow (sccm) | H₂ flow (sccm) | AlScN etch rate (nm/min) | Mo etch Rate (nm/min) | AlScN:Mo selectivity |
|---|---|---|---|---|---|---|
| Process 1 | 18 | 102 | 0 | 107.12 | 35.35 | 3.0:1 |
| Process 2 | 18 | 102 | 18 | 97.54 | 24.53 | 3.9:1 |
| Process 3 | 18 | 102 | 27 | 87.19 | 20.64 | 4.2:1 |

During the first process (process 1), which served as a control process, no H₂ was introduced into the chamber. During this process, it is evident that the AlScN etch rate was substantially 107nm/min and the Mo etch rate was substantially 35 nm/min. During process 2, H₂ gas was introduced with a flow rate of substantially 18sccm and this resulted in a decreased AlScN etch rate of substantially 97nm/min and a decreased Mo etch rate of substantially 24nm/min. As the H₂ flow rate was increased further in process 3 to 27sccm, the AlScN etch rate further decreased to substantially 87nm/min and the Mo etch rate further decreased to 20nm/min.

The results demonstrate that the AlScN:Mo selectivity increases with an increasing flow rate of H₂ gas into the chamber. It is believed that the BCl₃ gas dissociates into BCl₂, BCI, Cl and B and that the H₂ reacts with Cl and forms HCl which reduces the amount of available Cl and significantly reduces Mo etch rate. On the other hand, the decrease in AlScN etch rate is lower than the decrease in Mo etch rate as in this process regime, big sputter mass of Boron helps sputtering of AlClₓ and ScCl₃ based by-products which maintains AlScN etch rate. For electrodes, namely underlayers 11b formed on the underside of a piezoelectric film 11c, which etch readily in a chlorine-based chemistry, such as Mo, decreasing the Cl₂ presence and introducing a H₂ gas into the chamber is found to decrease the underlayer etch rate.

The process of etching a workpiece 11 comprising an AlScN film 11c deposited on a Mo film 11b therefore comprises a main etching step 100 for etching a trench through the majority of the AlScN film 11c, and a soft-landing etching step 200 which takes place immediately after the main etching stage 100, and which is commenced prior to the trench extending out from the AlScN layer 11c. As a consequence of the introduction of H₂ gas into the chamber 12 during the soft-landing step it has been demonstrated above that an improved selectivity to the lower electrode metal film can be achieved.

## Claims

1. A method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
introducing BCl₃ gas into the chamber with a BCl₃ flow rate in sccm;
introducing H₂ gas into the chamber with a H₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the BCl₃ flow rate is in the range 1:3 to 1:11 and a ratio of the BCl₃ flow rate to the H₂ flow rate is in the range 11:1 to 2:1.

2. A method according to claim 1 in which the ratio of the inert diluent gas flow rate to the BCl₃ flow rate is in the range 1:5 to 1:6.

3. A method according to claim 1 or claim 2 in which the ratio of the BCl₃ flow rate to the H₂ flow rate is in the range 5.7:1 to 3.8:1.

4. A method according to any one of claims 1 to 3 in which the BCl₃ flow rate is in the range 90 to 110 sccm.

5. A method according to any one of claims 1 to 4 in which the inert diluent gas flow rate is in the range 10 to 30 sccm.

6. A method according to any one of claims 1 to 4 in which the H₂ gas flow rate is in the range 10 to 40 sccm.

7. A method according to any preceding claim in which an RF bias signal having a power in the range 500-700W is applied to the substrate support during the plasma etch step.

8. A method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
performing a first plasma etching step in which BCl₃ gas, Cl₂ gas and an inert diluent gas are introduced into the chamber and a plasma is established within the chamber to plasma etch a majority of the additive-containing aluminium nitride film exposed within the trench; and
performing a second plasma etching step to plasma etch the remaining additive-containing aluminium nitride film exposed within the trench to reveal the metal film, the second plasma etching step comprising:
introducing BCl₃ gas into the chamber with a BCl₃ flow rate in sccm;
introducing H₂ gas into the chamber with a H₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein during the second plasma etching step, a ratio of the inert diluent gas flow rate to the BCl₃ flow rate is in the range 1:3 to 1:11 and a ratio of the BCl₃ flow rate to the H₂ flow rate is in the range 11:1 to 2.25:1.

9. A method according to claim 8, wherein the second plasma etching step further comprises the method according to any of claims 2-7.

10. A method according to claim 8 or 9, wherein the second plasma etching step takes place separately to the first plasma etching step.

11. A method according to any of claims 8-10, wherein the second plasma etching step take places immediately after the first plasma etching step.

12. A method according to any of claims 8-11 in which Cl₂ gas is not introduced into the chamber during the second plasma etching step.

13. A method according to any preceding claim in which:
a) the inert diluent gas is Argon; and/or
b) the metal film is a molybdenum film; and/or
c) the mask is a photoresist mask; and/or
d) the plasma is an inductively coupled plasma (ICP); and/or
e) a pressure within the plasma chamber is in the range 2-5mTorr during the plasma etching of the additive-containing aluminium nitride film exposed within the trench; and/or
f) the substrate is a semiconductor substrate, optionally a silicon substrate; and/or
g) the additive-containing aluminium nitride film is an aluminium scandium nitride film defined by the formula AlₓSc_{y}N, where x + y = 1; and wherein the scandium content y is at least 0.35

14. An apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas with a BCl₃ flow rate in sccm, H₂ gas with a H₂ flow rate in sccm and an inert diluent gas with an inert diluent flow rate in sccm;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform plasma etching to etch the additive-containing aluminium nitride film exposed within the trench, wherein a ratio of the inert diluent gas flow rate to the BCl₃ flow rate in the range 1:3 to 1:11 and a ratio of the BCl₃ flow rate to the H₂ flow rate in the range 11:1 to 2.25:1.

15. An apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas, Cl₂ gas, H₂ gas and an inert diluent gas;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform:
a first plasma etching step in which BCl₃ gas, Cl₂ gas and an inert diluent gas are introduced into the chamber and a plasma is established within the chamber to etch a majority of the additive-containing aluminium nitride film exposed within the trench, and
a second plasma etching step in which BCl₃ gas, H₂ gas and an inert diluent gas are introduced into the chamber, such that a ratio of the inert diluent gas flow rate to the BCl₃ flow rate is in the range 1:3 to 1:11 and a ratio of the BCl₃ flow rate to the H₂ flow rate is maintained in the range 11:1 to 2.25:1, and a plasma is established within the chamber to etch the remaining additive-containing aluminium nitride film exposed within the trench to reveal the metal film.
